# EUROPEAN PATENT APPLICATION

(11) **EP 4 567 882 A1**
(43) Date of publication of application: **11.06.2025**
(21) Application number: 23213970.9
(22) Date of filing: 04.12.2023
(51) Int. Cl.: H01L 23/495

(54) **SEMICONDUCTOR PACKAGE HAVING A LEADFRAME WITH A METAL-PLATED BOND AREA**

(71) Applicant: Infineon Technologies Austria AG, 9500 Villach (AT)
(72) Inventor: TAN, Yi Ting, 77200 Melaka (MY); SAW, Bee Kwan, 75000 Melaka Tengah (MY); TOMMY KHOO, Chwee Pang, 75250 Melaka (MY); LAU, Kah Wai, 75460 Duyung (MY); CHAN, Poh Keng, 76400 Tanjung Kling (MY); GOH, Zhi Yuan, 76450 Bertam (MY); MOHAMED, Abdul Rahman, 84000 Muar (MY)
(74) Representative: Lambsdorff & Lange Patentanwälte Partnerschaft mbB

(57) **Abstract**

A semiconductor package comprises a semiconductor die having a first surface and a second surface opposite the first surface. A die pad is disposed at the first surface of the semiconductor die. A leadframe comprises a carrier section on which the semiconductor die is mounted, wherein the semiconductor die is solder-bonded to the carrier section with the second surface facing the carrier section. A metal-plated bond area is provided on the carrier section of the leadframe, wherein a metal of the metal-plated bond area is different from a metal of the leadframe. An electrical conductor is connected to the die pad and bonded to the metal-plated bond area. The metal-pated bond area has a substantially triangular shape.

## Description

### Technical Field

This disclosure relates generally to the field of semiconductor die packaging, and in particular to the field of semiconductor packages having a leadframe with a metal-plated bond area.

### Background

Semiconductor device manufacturers are constantly striving to increase the performance of their products, while decreasing their cost of manufacture. A cost and device performance sensitive area in the manufacture of a semiconductor device is packaging the semiconductor die. Packaging involves encapsulating the semiconductor die and forming an interconnect from die pads to package terminals. The packaging concept and interconnect technology should provide for high electrical and thermal performance and reliability of the semiconductor device. They should further support package scalability and die shrinkage.

Some types of packages use so-called spot-plated leadframes. Spot-plated leadframes provide a metal-plated bonding area (spot) that allows the leadframe to be connected via a conductor (e.g., a bond wire) to a semiconductor die mounted on the leadframe.

Providing a metal-plated bond area can increase the size of the leadframe. To keep this increase in size small, the metal-plated bonding area should be placed as close to the die (semiconductor chip) as possible. On the other hand, if the metal-plated bond area is placed too close to the die, it may interfere with the die attach process.

### Summary

According to an embodiment of a semiconductor package, the semiconductor package comprises a semiconductor die having a first surface and a second surface opposite the first surface. A die pad is disposed at the first surface of the semiconductor die. A leadframe comprises a carrier section on which the semiconductor die is mounted, wherein the semiconductor die is solder-bonded to the carrier section with the second surface facing the carrier section. A metal-plated bond area is provided on the carrier section of the leadframe, wherein a metal of the metal-plated bond area is different from a metal of the leadframe. An electrical conductor is connected to the die pad and bonded to the metal-plated bond area. The metal-pated bond area has a substantially triangular shape.

### Brief description of the drawings

The elements of the drawings are not necessarily to scale relative to each other. Like reference numerals designate corresponding similar parts. The features of the various illustrated examples can be combined unless they exclude each other and/or can be selectively omitted if not described to be necessarily required. Examples are depicted in the drawings and are exemplarily detailed in the description which follows.
Figure 1 is a schematic plan view illustrating a carrier section of a leadframe on which a semiconductor die is mounted and a metal-plated bond area is provided.
Figure 2A is a schematic cross-sectional view of an example of a lowered metal-plated bond area.
Figure 2B is a schematic cross-sectional view of an example of a raised metal-plated bond area.
Figure 3 is a schematic plan view illustrating an obstacle for solder creepage arranged between the metal-plated bond area and the semiconductor die.
Figure 4A is a schematic cross-sectional view of a first example of an obstacle for solder creepage.
Figure 4B is a schematic cross-sectional view of a second example of an obstacle for solder creepage.
Figure 5 is a schematic cross-sectional partial view of an example of a molded semiconductor package using a leadframe having a metal-plated bond area.
Figure 6 is a schematic plan view of an example of a semiconductor package including a leadframe having a carrier section on which a semiconductor die is mounted and a metal-plated bond area is provided.
Figure 7 is a schematic of a semiconductor die package including a GaN dual gate bidirectional switch.
Figure 8 is a perspective view of a semiconductor die package including a GaN dual gate bidirectional switch.
Figure 9 is a schematic plan view of an example of a semiconductor package similar to the semiconductor package of Figure 6, wherein two metal-plated bond areas are provided on the carrier section.

### Detailed description

The words "over" or "on" or "beneath" with regard to a part, element or material layer formed or located or disposed or arranged or placed "over" or "on" or "beneath" a surface may be used herein to mean that the part, element or material layer be located (e.g. placed, formed, arranged, disposed, placed, etc.) "directly on" or "directly under", e.g. in direct contact with, the implied surface. The word "over" or "on" or "beneath" used with regard to a part, element or material layer formed or located or disposed or arranged or placed "over" or "on" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

As used in this specification, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

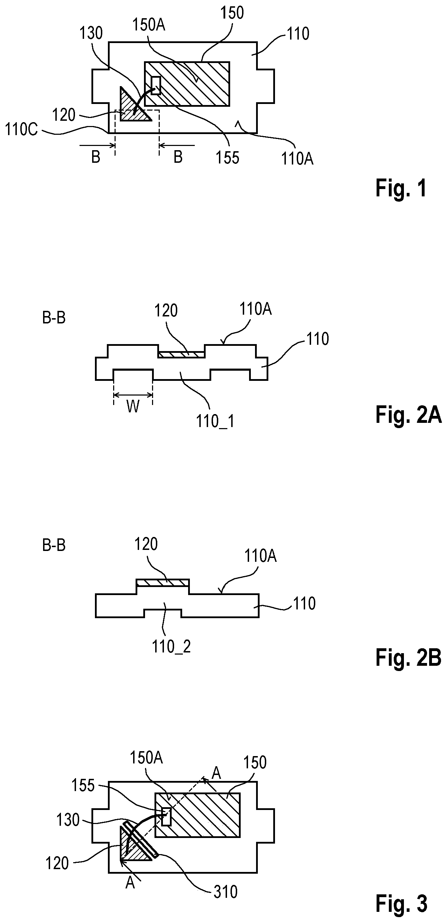

Figure 1 illustrates a carrier section 110 of a leadframe (which is not shown except of the carrier section 110 in Figure 1). A semiconductor die 150 is mounted on the carrier section 110. The semiconductor die 150 has a first surface 150A. A die pad 155 is disposed at the first surface 150A of the semiconductor die 150. The semiconductor die 150 is solder-bonded to the carrier section 110 with the second surface of the semiconductor die 150 opposite the first surface 150A facing the carrier section 110.

The carrier section 110 is provided with a metal-plated bond area 120. The metal-plated bond area 120 comprises or is made of a metal which allows the leadframe (or, more specifically, the carrier section 110 of the leadframe) to be connected to an electrical conductor 130. To this end, the metal of the metal-plated bond area 120 is different from a metal of the leadframe (or, more specifically, a metal of the carrier section 110 of the leadframe). The electrical conductor 130 is connected to the die pad 155 of the semiconductor die 150.

As illustrated in Figure 1, the metal-plated bond area 120 has a substantially triangular shape.

A "substantially triangular shape" means that the shape is triangular (i.e. has three sides) or is triangular with one or two or three cut or rounded edges, i.e. is a "truncated" triangle. Further, the sides of the triangle need not to be straight lines, but may fluctuate or oscillate. In other words, the phrase "substantially triangular shape" may include certain deviations from an "ideal" triangle.

In the following the shape of the metal-plated bond area 120 is referred to as a triangular shape, keeping in mind that this wording encompasses triangular and truncated triangular shapes as described above.

The triangular shape is less space consuming compared to square, rectangular, rounded or other shapes. Therefore, the size of the carrier section 110 may be kept small. Furthermore, the triangular shape may be oriented with respect to the outline of the semiconductor die 150 such that a corner of the die faces a side (e.g., the longest side) of the triangular shape. That way, interference between the metal-plated bond area 120 and the semiconductor die 150 may be minimized during die attach.

The metal-plated bond area 120 may be arranged close to a corner 110C of the carrier section 110. The triangular shape of the metal-plated bond area 120 may be aligned with the corner 110C. For example, two sides of the triangular shape may be arranged substantially parallel with proximate edges of the carrier section 110.

The metal-plated bond area 120 may be arranged close to a corner of the semiconductor die 150. For example, the corner of the semiconductor die, which is closed to the metal-plated bond area 120, may face the longest side of the triangular shape of the metal-plated bond area 120.

A variety of different triangular shapes may be used. For example, the triangular shape may be a rectangular triangular shape. In this case, typically, the hypotenuse of the triangle faces the corner of the semiconductor die 150 which is closest to the metal-plated bond area 120.

For example, if the triangle is rectangular in shape, an imaginary line between the rectangular corner of the triangle and the corner of the semiconductor die 150 may intersect the hypotenuse of the triangle in or near its center. Furthermore, two sides of the rectangular or non-rectangular triangle may have the same length.

The carrier section 110 and thus the leadframe may comprise or be of copper or copper alloy, for example. An upper surface 110A of the carrier section 110 may be solderable. The semiconductor die 150 may be soldered to the (solderable) surface 110A of the carrier section 110 with soft solder.

The metal-plated bond area 120 may comprise a bondable metal material configured to allow bonding the electrical conductor 130 to the carrier section 110. The material of the metal-plated bond area 120 may be different from the material which forms the solderable surface 110A of the carrier section 110. For example, the material of the metal-plated bond area 120 may comprise or be a precious metal, e.g. silver or a silver alloy.

The material of the metal-plated bond area 120 may depend on the type of the electrical conductor 130, the material of the electrical conductor 130 and/or the process used for bonding. For example, the electrical conductor 130 may be a bond wire. The electrical conductor may be made of or comprise copper or a copper alloy, aluminum or an aluminum alloy or gold or a gold alloy, for example. If the electrical conductor 130 is a bond wire, all known wire bonding processes may be used.

In other examples the electrical conductor 130 may be a clip. In this case, a clip bonding process is used to connect the clip to the metal-plated bond area 120.

As known in the art, especially with semiconductor dies 150 of large size, there is a tendency of solder creepage to the metal-plated bond area 120 during die attach. Solder creepage (also known as "solder bleeding") of the liquid solder during die attach is critical since it may result in that the solder may cover the metal-plated bond area 120 and thus impair its ability for bonding. Further, the semiconductor die 150 may be tilted by solder creepage.

Figure 2A illustrates a sectional view along sectional line B-B of Figure 1 of the carrier section 110. As shown in Figure 2A, the metal-plated bond area 120 may be formed in a lowered part 110_1 of the carrier section 110. For example, the lowered part 110_1 may be formed by embossing the carrier section 110 in a zone comprising the metal-plated bond area 120. More specifically, the carrier section 110 of the leadframe may first be spot-plated with the metal of the metal-plated bond area 120 and then embossed around the plated area. As a result, a well design as shown in Figure 2A may be obtained.

The height of the walls measured from the upper surface 110A of the carrier section 110 to the metal surface of the metal-plated bond area 120 may be equal to or greater than or less than 0.15 mm or 0.25 mm or 0.35 mm. The width W of the wall may, e.g., be equal to or greater than or less than 0.3 mm or 0.4 mm or 0.5 mm. The area of the metal-plated bond area 120 may be equal to or greater than or less than 0.5 mm², 0.75 mm², 1.0 mm², 1.25 mm², or 1.5 mm²' for example.

Figure 2B illustrates another example of a carrier section 110. In this example, the metal-plated bond area 120 is formed on an elevated zone of the carrier section 110. That is, the upper surface 110A of the carrier section 110 is raised in a zone carrying the metal-plated bond area 120.

For example, the metal-plated bond area 120 may first be formed by spot-plating the carrier section 110 with the metal of the metal-plated bond area 120. The elevated part 110_2 of the carrier section 110 may then be formed by a mechanical machining process such as, e.g., embossing.

Referring to Figure 3, in some examples an obstacle 310 for solder creepage may be arranged between the semiconductor die 150 and the metal-plated bond area 120. The obstacle 310 may, e.g., have a longitudinal and/or linear shape. The obstacle 310 may, e.g., run substantially parallel with a side of the triangular shape of the metal-plated bond area 120, e.g. with the longest side (e.g., the hypotenuse) of the triangle.

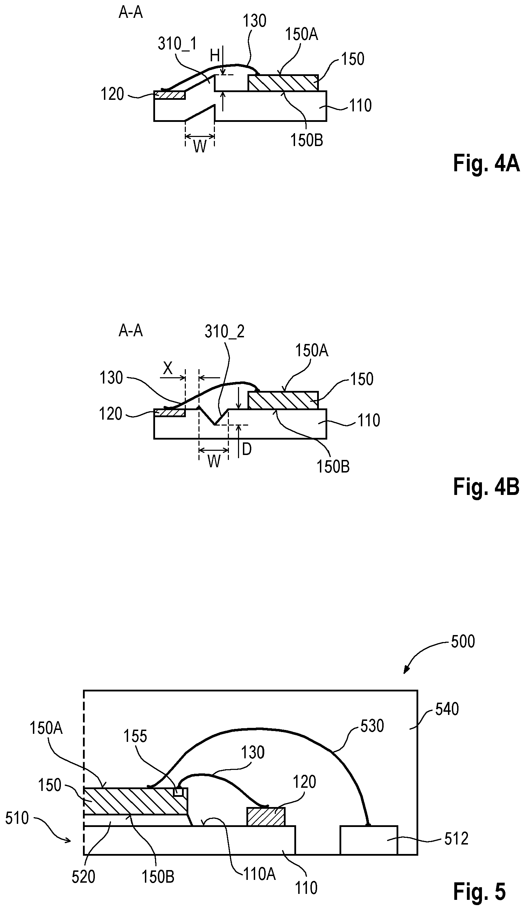

Referring to Figure 4A illustrating a cross-sectional view along line A-A of Figure 3, the obstacle 310 may comprise a wall 310_1 formed on the carrier section 110, for example. The wall 310_1 may be formed by mechanical machining, e.g. embossing. The wall 310_1 may have a height H equal to or greater than or less than 0.15 mm or 0.25 mm or 0.35 mm. The width W of the wall 310_1 may be equal to or greater than or less than 0.3 mm or 0.4 mm or 0.5 mm.

Referring to Figure 4B, the obstacle 310 may comprise a groove 310_2 formed in the carrier section 110. The groove 310_2 may be formed by mechanical machining, e.g., by embossing. For example, first the metal of the metal-plated bond area 120 is spot-plated on the carrier section 110 and then the groove 310_2 is formed by mechanical machining, e.g. by embossing.

The depth D of the groove 310_2 may be greater than the width W of the groove 310_2. For example, the depth D of the groove 310_2 may be equal to or greater than or less than 0.4 mm, 0.6 mm or 0.8 mm. The width W of the groove 310_2 may, e.g., be equal to or greater than or less than 0.05 mm or 0.1 mm or 0.15 mm. The groove 310_2 may have a distance X from the metal-plated bond area 120 which is equal to or greater than or less than 0.2 mm or 0.3 mm or 0.4 mm, for example.

The semiconductor die 150 comprises or is of a semiconductor material. Examples of such semiconductor materials include, but are not limited to, elementary semiconductor materials such as silicon (Si) or germanium (Ge), group IV compound semiconductor materials such as silicon carbide (SiC) or silicon germanium (SiGe), binary, ternary or quaternary III-V semiconductor materials such as gallium nitride (GaN), gallium arsenide (GaAs), gallium phosphide (GaP), indium phosphide (InP), indium gallium phosphide (InGaPa), aluminum gallium nitride (AlGaN), aluminum indium nitride (AlInN), indium gallium nitride (InGaN), aluminum gallium indium nitride (AlGaInN) or indium gallium arsenide phosphide (InGaAsP), etc.

The semiconductor die 150 may have die pads 155 (only) at its first surface 150A. In other examples, the semiconductor die 150 may have die pads 155 at its first surface 150A and at its second surface 150B.

In some examples, the semiconductor die 150 may be a transistor. For example, the semiconductor die 150 (e.g., a semiconductor chip) may, for example, be configured as an IGBT (Insulated Gate Bipolar Transistor), a FET (Field Effect Transistor), in particular a MOSFET (Metal Oxide Semiconductor FET) such as, e.g., a P-FET (P-channel FET), an N-FET (N-channel FET), an AFET (Array-FET), a JFET (Junction gate FET), a planar gate transistor, a field plate trench transistor, or a SJ (super junction) transistor.

In some examples, the semiconductor die 150 may be a power die. The semiconductor die 150 may, e.g., be a vertical device in which the main direction of the load current is in vertical direction to the die plane. By way of example, a power pad (e.g., source or emitter pad) and a gate pad may be located at the first surface 150A of the semiconductor die 150, while another power pad (e.g., drain or collector pad) may be provided at the second surface 150B of the semiconductor die 150.

In other examples, the semiconductor die 150 may, e.g., be a horizontal or lateral device, in which the main direction of the load current is in a horizontal or lateral direction with the substrate plane. In this case, a first power pad (e.g., source or emitter pad), a second power pad (e.g., drain pad or collector pad) and a gate pad may be located at the first surface 150A of the semiconductor die 150, while no die pads are located at the second surface 150B of the semiconductor die 150. This disclosure is not limited to any particular FEOL (front-end-of-line) integration, but a variety of different FEOL integrations (or device types) may benefit from this disclosure.

As a specific example, the semiconductor die 150 may be a GaN power transistor, in particular a GaN HEMT (high electron mobility transistor), in more in particular a bidirectional GaN transistor.

Figure 5 illustrates a partial cross-sectional view of a semiconductor package 500. A leadframe 510 may include the carrier section 110 (also referred to as "paddle" in the art) and a package wiring contact section 512. The package wiring contact section 512 is connected by a package wiring 530 (e.g., bond wire or clip) to one or more die pads (not shown) of the semiconductor die 150.

The semiconductor die 150 is mounted by solder 520, e.g., soft solder, on the carrier section 110. The semiconductor package 500 may further comprise a mold compound 540, which encapsulates the semiconductor die 150, the electrical conductor 130, the package wiring 530 and, at least partly, the leadframe 510.

As shown by way of example in Figure 5, the package 500 may, e.g., be a no-lead package. Such packages are also known as leadless leadframe packages. In such type of packages, the package wiring contact section 512 may form, e.g., a package terminal located at the footprint of the semiconductor package 500.

In other examples (see below) the semiconductor package 500 may have leads protruding laterally out of the package 500. In this case, the package wiring contact sections 512 may be designed as leads which protrude laterally out of the mold compound 540. They may or may not be exposed at the footprint side of the semiconductor package 500.

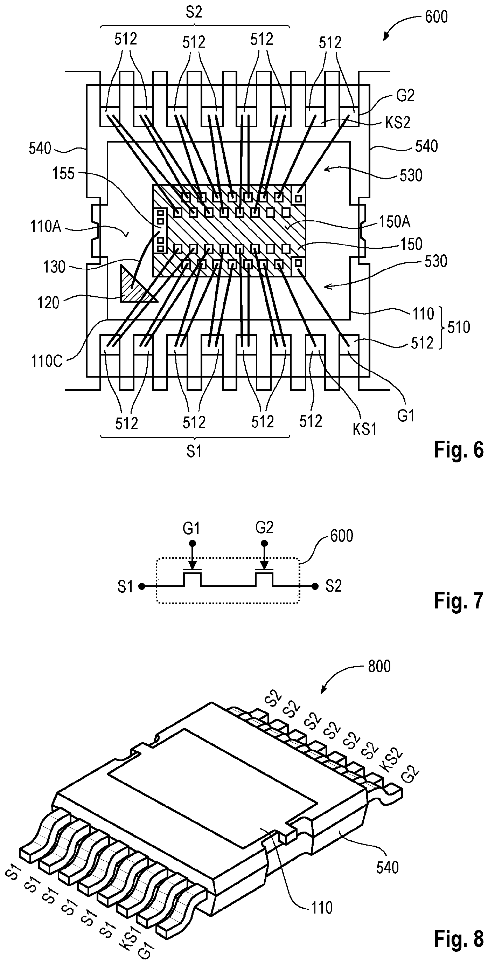

In all examples the carrier section 110 of the leadframe 510 may or may not be exposed at the periphery of the mold compound 540. As shown in Figure 5, in some examples the carrier section 110 may be exposed at the footprint side of the semiconductor package. In other examples the carrier section 110 may, e.g., be exposed at the top side of the semiconductor package (see, e.g., Figure 8), while the package wiring contact section 512 is either formed as a contact section at the footprint side of the semiconductor package 500 or is formed as a lead protruding laterally out of the mold compound 540.

Figure 6 illustrates an example of a semiconductor package 600. In Figure 6, the mold compound 540 is shown transparent to allow a view into the package 600.

The semiconductor package 600 is similar to the semiconductor package 500, and reference is made to the above description to avoid reiteration. Figure 6 illustrates that a plurality of package wirings 530 and/or a plurality of package wiring contact sections 512 may be provided. For example, at one lateral side of the semiconductor package 600 eight package wiring contact sections 512 (e.g., footprint terminals or leads) may be provided, and/or at another lateral side (e.g., opposite side), also a plurality (e.g., eight) package wiring contact sections 512 are provided. Further, Figure 6 illustrates the metal-plated bond area 120 of triangular shape, which is bonded to a die pad 155 of the semiconductor die 150.

Referring further to Figures 7 and 8, the semiconductor package 600 may, e.g., be a package including a semiconductor die 150 which is, e.g., a GaN-HEMT (high electron mobility transistor). More specifically, the semiconductor die 150 may be a dual gate bidirectional switch. Such switches use the (unique) nature of a GaN-HEMT, namely to allow for bidirectional switching.

A GaN dual gate bidirectional switch may eliminate the need to use two silicon devices in series of half the R_{DS(ON)}. Therefore, it may provide low cost and enabling new topologies to gain application advantages.

Referring to Figure 7, a dual gate bidirectional GaN-HEMT switch has two source terminals S1, S2 and two gate terminals G1, G2. The two GaN transistors may have a common drain configuration (e.g., die-internally connected drains), for example. The common drains may be floating and cannot be contacted from the outside, for example. Further, Kelvin sense terminals (not shown in Figure 7) may be provided. A ground terminal may, e.g., be provided by the carrier section 110 of the leadframe 510. That is, the carrier section 110 may be on substrate ground potential during operation of the semiconductor package 500.

More specifically, here and in all other examples, the chip pad 155 may be used to ground the semiconductor die substrate. The die pad 155 may, e.g., be connected to a substrate pinning circuit intended to pin the semiconductor die substrate to the respective source S1, S2 which has lower voltage.

Figure 6 illustrates an exemplary leadframe design and an exemplary allocation of package terminals (e.g., wiring contact sections 512) to die pads of the semiconductor die 150. A first gate terminal is denoted by G1, a second gate terminal is denoted by G2, first source terminals are denoted by S1 and second source terminals are denoted by S2. Further, one package wiring contact section 512, denoted by KS1, is connected by package wiring 530 to a first Kelvin sense die pad of the semiconductor die 150, and another package wiring contact section 512, denoted by KS2, is connected by package wiring 530 to a second Kelvin sense die pad of the semiconductor die 150.

In this example, the die pad 155, connected to the metal-plated bond area 120, is a ground die pad of the semiconductor die 150. However, as already mentioned, basically any die pad of the semiconductor die 150 may be connected by the electrical conductor 130 to the metal-plated bond area 120 of the carrier section 110. More specifically, the die pad which is connected to the metal-plated bond area 120 may, alternatively, be a gate pad or a sense Kelvin pad or a load current pad, for example.

Figure 8 illustrates a semiconductor package 800 which may be identical to the semiconductor package 600 shown in Figure 6 in terms of the packaged device, the internal package wiring and the package terminals. As in the semiconductor package 600 of Figure 6, the package wiring contact sections 512 (one or more of package terminals S1, KS1, G1, S2, KS2, G2, for example) may, e.g., be formed by leads protruding laterally out of the mold compound 540. The semiconductor package 800 may distinguish from the semiconductor package 500 and/or 600 in that it is a top-side cooled package. That is, the carrier section 110 of the leadframe 510 may, e.g., be exposed at the top side (not footprint side) of the semiconductor package 800.

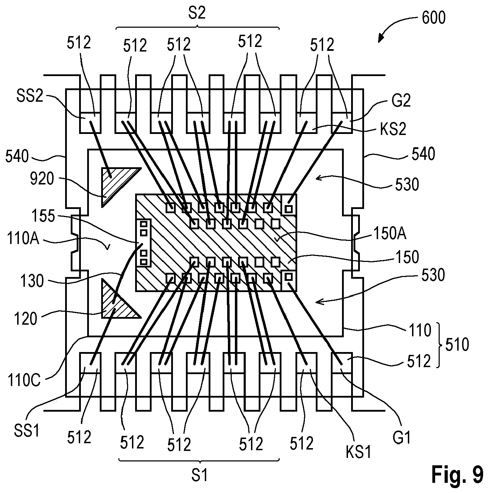

Figure 9 illustrates an example of a semiconductor package 900. As in Figure 6, the mold compound 540 is shown transparent to allow a view into the package 900.

The semiconductor package 900 is similar to the semiconductor package 600, and reference is made to the above description to avoid reiteration. In semiconductor package 900, a further metal-plated bond area 920 may, e.g., be provided on the carrier section 110. The further metal-plated bond area 920 may be arranged close to another corner of the carrier section 110.

The further metal-plated bond area 920 may be located and/or designed similar or identical with the metal-plated bond area 120. Although the further metal-plated bond area 920 is illustrated for the example of a dual gate bidirectional GaN-HEMT switch, it may be used in any of the semiconductor packages described herein.

The further metal-plated bond area 920 may be used for sensing the leadframe potential (i.e., the potential of the carrier section 110 of the leadframe, which may, e.g., be identical to the substrate potential of semiconductor die 150). To this end, a package wiring contact section 512, denoted by SS2, may be connected by a conductor (e.g., a bond wire) to the further metal-plated bond area 920.

Optionally, alternatively or additionally, the metal-plated bond area 120 may (in this example and/or in all other examples of semiconductor packages) also be used for sensing the leadframe potential, for example. In this case, a package wiring contact section 512, denoted by SS1, may be connected by a conductor (e.g., a bond wire) to the metal-plated bond area 120.

In the semiconductor packages 600, 900, an obstacle for solder creepage (not shown in Figures 6 and 9) may be arranged between the semiconductor die 150 and the metal-plated bond area 120 and/or the further metal-plated bond area 920. Reference is made to the description of obstacles 310, 310_1, 310_2 shown in Figures 3, 4A to 4B, for example.

The semiconductor package 900 may be designed in accordance with semiconductor package 800 shown in Figure 8. Referring to semiconductor package 900, the package wiring contact sections 512 may represent one or more of package terminals S1, KS1, G1, S2, KS2, G2, SS1, SS2, for example.

### EXAMPLES

The following examples pertain to further aspects of the disclosure:
Example 1 is a semiconductor package including a semiconductor die having a first surface and a second surface opposite the first surface. A die pad is disposed at the first surface of the semiconductor die. A leadframe comprises a carrier section on which the semiconductor die is mounted, wherein the semiconductor die is solder-bonded to the carrier section with the second surface facing the carrier section. A metal-plated bond area is provided on the carrier section of the leadframe, wherein a metal of the metal-plated bond area is different from a metal of the leadframe. An electrical conductor is connected to the die pad and bonded to the metal-plated bond area. The metal-pated bond area has a substantially triangular shape.
In Example 2, the subject matter of Example 1 can optionally include wherein the metal-plated bond area is arranged close to a corner of the carrier section, the triangular shape being aligned with the corner.
In Example 3, the subject matter of Example 1 or 2 can optionally include wherein the metal-plated bond area is arranged close to a corner of the semiconductor die, the corner of the semiconductor die facing the longest side of the triangular shape.
In Example 4, the subject matter of any of the preceding Examples can optionally include wherein the triangular shape is a rectangular triangular shape.
In Example 5, the subject matter of any of the preceding Examples can optionally further include an obstacle for solder creepage arranged between the semiconductor die and the metal-plated bond area.
In Example 6, the subject matter of Example 5 can optionally include wherein the obstacle comprises a wall formed on the carrier section.
In Example 7, the subject matter of Example 5 or 6 can optionally include wherein the obstacle comprises a groove formed in the carrier section.
In Example 8, the subject matter of any of the preceding Examples can optionally include wherein the metal-plated bond area is formed on an elevated zone of the carrier section.
In Example 9, the subject matter of any of the preceding Examples can optionally include wherein a distance between the semiconductor die and the metal-plated bond area is equal to or smaller than 0.5 mm or 0.4 mm or 0.35 mm or 0.3 mm or 0.25 mm or 0.2 mm.
In Example 10, the subject matter of any of the preceding Examples can optionally include wherein the electrical conductor comprises a bond wire.
In Example 11, the subject matter of any of the preceding Examples can optionally include wherein the electrical conductor comprises a clip.
In Example 12, the subject matter of any of the preceding Examples can optionally include wherein the metal of the metal-plated bond area comprises or is of Ag or an Ag-based alloy.
In Example 13, the subject matter of any of the preceding Examples can optionally include wherein the semiconductor die comprises a wide bandgap semiconductor material, in particular GaN.
In Example 14, the subject matter of any of the preceding Examples can optionally include wherein the semiconductor die is a power die.
In Example 15, the subject matter of any of the preceding Examples can optionally include wherein the semiconductor die comprises a transistor, and the die pad is a gate pad or a sense Kelvin pad or a ground pad or a load current pad.
In Example 16, the subject matter of any of the preceding Examples can optionally include wherein the semiconductor die comprises a bidirectional GaN transistor, in particular a bidirectional GaN high electron mobility transistor.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

## Claims

1. A semiconductor package, comprising:
a semiconductor die having a first surface and a second surface opposite the first surface;
a die pad disposed at the first surface of the semiconductor die;
a leadframe comprising a carrier section on which the semiconductor die is mounted, wherein the semiconductor die is solder-bonded to the carrier section with the second surface facing the carrier section;
a metal-plated bond area on the carrier section of the leadframe, wherein a metal of the metal-plated bond area is different from a metal of the leadframe; and
an electrical conductor connected to the die pad and bonded to the metal-plated bond area; wherein
the metal-pated bond area has a substantially triangular shape.

2. The semiconductor package of claim 1, wherein the metal-plated bond area is arranged close to a corner of the carrier section, the triangular shape being aligned with the corner.

3. The semiconductor package of claim 1 or 2, wherein the metal-plated bond area is arranged close to a corner of the semiconductor die, the corner of the semiconductor die facing the longest side of the triangular shape.

4. The semiconductor package of any of the preceding claims, wherein the triangular shape is a rectangular triangular shape.

5. The semiconductor package of any of the preceding claims, further comprising:
an obstacle for solder creepage arranged between the semiconductor die and the metal-plated bond area.

6. The semiconductor package of claim 5, wherein the obstacle comprises a wall formed on the carrier section.

7. The semiconductor package of claim 5 or 6, wherein the obstacle comprises a groove formed in the carrier section.

8. The semiconductor package of any of the preceding claims, wherein the metal-plated bond area is formed on an elevated zone of the carrier section.

9. The semiconductor package of any of the preceding claims, wherein a distance between the semiconductor die and the metal-plated bond area is equal to or smaller than 0.5 mm or 0.4 mm or 0.35 mm or 0.3 mm or 0.25 mm or 0.2 mm.

10. The semiconductor package of any of the preceding claims, wherein the electrical conductor comprises a bond wire.

11. The semiconductor package of any of the preceding claims, wherein the electrical conductor comprises a clip.

12. The semiconductor package of any of the preceding claims, wherein the metal of the metal-plated bond area comprises or is of Ag or an Ag-based alloy.

13. The semiconductor package of any of the preceding claims, wherein the semiconductor die comprises a wide bandgap semiconductor material, in particular GaN.

14. The semiconductor package of any of the preceding claims, wherein the semiconductor die is a power die.

15. The semiconductor package of any of the preceding claims, wherein the semiconductor die comprises a transistor, and the die pad is a gate pad or a sense Kelvin pad or a ground pad or a load current pad.

16. The semiconductor package of claim 13, wherein the semiconductor die comprises a bidirectional GaN transistor, in particular a bidirectional GaN high electron mobility transistor.
